# FASCICULE DE BREVET EUROPEEN

(11) **EP 2 434 849 B1**
(45) Date de publication et mention de la délivrance du brevet: **02.12.2015**
(21) Numéro de dépôt: 11182445.4
(22) Date de dépôt: 23.09.2011
(51) Int. Cl.: H05K 5/06

(54) **Boîtier électronique pour véhicule**
Elektronikgehäuse für Fahrzeug
Electronic module for vehicle

(30) Priorité: 23.09.2010 FR 1057648
(43) Date de publication de la demande: 28.03.2012
(73) Titulaire: Valeo Systèmes de Contrôle Moteur, 95800 Cergy (FR)
(72) Inventeur: Moreno, Jean-Yves, 60110 Meru (FR); Govindassamy, Valery, 95150 Taverny (FR); Silvestre, Bénédicte, 78740 Vaux sur Seine (FR)

(56) Documents cités:
- EP-A1- 2 120 263
- JP-A- 2003 318 568
- JP-A- 2009 130 230

## Description

### DOMAINE TECHNIQUE

L'invention se rapporte à un boîtier électronique destiné à être embarqué dans un véhicule, en particulier dans un véhicule automobile. Elle concerne tout assemblage de cartes électroniques ou PCB (pour « Printed-Circuit Board ») installées sur un carter métallique ou plastique (électronique de puissance, électronique de commande), dans un environnement mécatronique, électronique embarquée. Bien qu'une application particulière soit celle de l'automobile, l'invention peut s'appliquer à des domaines présentant des contraintes d'utilisation proches ou similaires.

### ÉTAT DE LA TECHNIQUE ANTÉRIEURE

Actuellement les boîtiers électroniques embarqués dans une automobile sont soumis à des chocs thermiques et à des vibrations suivant les cahiers des charges respectifs de chaque constructeur. Pour respecter les exigences de qualité de chaque constructeur, les cartes électroniques équipées (puissance et commande) sont fixées dans des carters, leurs interconnexions étant assurées par différentes technologies, notamment celle appelée « wedge bonding ».

La technique du « wedge bonding » se définit comme suit. Un fil, le plus souvent en aluminium est amené par un outil (appelé stylet ou aiguille), il est appliqué sur le plot à souder. La liaison entre le fil et la zone à connecter s'effectue en combinant pression et vibration ultrasonore. Il s'agit d'une soudure dite « à froid ». C'est l'énergie ultrasonique qui entraîne le ramollissement du fil, semblable à l'effet obtenu par une élévation de température. Le fil est ensuite guidé par l'outil sur le second plot et la soudure est effectuée. Les fils peuvent avoir des diamètres compris entre 75 µm et 650 µm.

Pour protéger ces soudures contre l'oxydation, les chocs thermiques, les vibrations et la chaleur humide on utilise des résines à base époxy ou acrylique ou des gels de silicone. Les résines sont déposées localement à l'aide de distributeurs. Elles sont polymérisées soit au four, soit par UV. Les gels de silicone sont coulés dans des zones de rétention dans lesquelles sont soudés les fils de liaison (« bonding ») .

Les résines époxy ou acryliques, ainsi que les gels de silicone, présentent de bonnes performances thermiques, d'isolation électrique et mécanique. Cependant, leur mise en oeuvre, pour les boîtiers électroniques embarqués est cause d'un coût de revient de ces boîtiers jugé excessif par les constructeurs automobiles notamment.

JP 2009 130 230 A divulgue un boîtier électronique selon la première partie de la revendication 1.

### EXPOSÉ DE L'INVENTION

Afin de remédier au problème de coût exposé ci-dessus, il est proposé de remplacer le matériau de protection des cartes électroniques disposées dans un carter (résine époxy, résine acrylique, gels de silicone) par une résine polyuréthane. La résine polyuréthane présente des performances thermiques, d'isolation électrique et mécanique équivalentes à celles des matériaux de l'art antérieur (résine époxy, résine acryline, gel de silicone), cependant le gain économique résultant du matériau et de sa mise en oeuvre est très important.

De par ses propriétés mécaniques et son expansion thermique (220. 10⁻⁶ m/°C), l'invention s'applique avantageusement sur des fils d'aluminium et sur des rubans d'aluminium.

L'invention a donc pour objet un boîtier électronique destiné à être embarqué dans un véhicule, selon la revendication 1.

L'une des deux cartes électroniques peut être une carte de puissance, l'autre carte électronique peut être une carte de commande.

Selon un premier mode de réalisation, la résine de protection enrobe complètement les cartes électroniques.

Selon un deuxième mode de réalisation, la résine de protection n'enrobe que la carte électronique de puissance. Dans ce cas, la carte de commande peut reposer sur la résine d'enrobage.

Le conducteur électrique peut être un fil d'aluminium. Il peut s'agir aussi d'un ruban d'aluminium.

Le carter peut avantageusement être en aluminium.

### BRÈVE DESCRIPTION DES DESSINS

L'invention sera mieux comprise et d'autres avantages et particularités apparaîtront à la lecture de la description qui va suivre, donnée à titre d'exemple non limitatif, accompagnée des dessins annexés parmi lesquels :
- la figure 1 représente un premier mode de mise en oeuvre de l'invention pour un boîtier électronique comprenant une carte électronique de puissance et une carte électronique de commande,
- la figure 2 représente un deuxième mode de mise en oeuvre de l'invention pour un boîtier électronique comprenant une carte électronique de puissance et une carte électronique de commande.

### EXPOSÉ DÉTAILLÉ DE MODES DE RÉALISATION PARTICULIERS

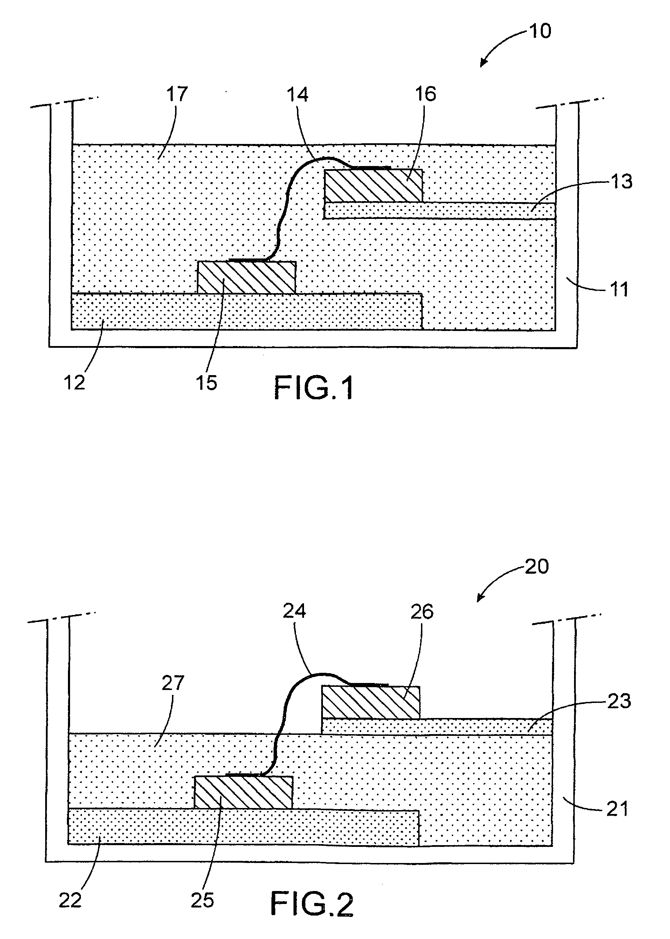

La figure 1 représente un boîtier électronique 10 destiné à être embarqué, à titre d'exemple, dans un véhicule automobile. Le boîtier comprend un carter 11, par exemple en aluminium, qui contient deux cartes électroniques 12 et 13. Les cartes électroniques 12 et 13 (ou PCB pour « Printing Circuit Board ») sont fixées au carter 11 par des moyens de fixation non représentés (entretoises, tiges filetées et écrous par exemple).

La carte électronique 12 est par exemple une carte de puissance et la carte électronique 13 est une carte de commande. On n'a représenté sur la figure 1, par souci de simplification, qu'un seul conducteur électrique 14 de liaison entre les deux cartes électroniques 12 et 13 mais il peut y en avoir plusieurs. De même, le boîtier 10 peut contenir plus de deux cartes électroniques, chaque carte pouvant être reliée à une autre carte par un ou plusieurs conducteurs électriques.

Le conducteur électrique 14 relie électriquement un plot électriquement conducteur 15 de la carte électronique 12 à un plot électriquement conducteur 16 de la carte électronique 13. Les extrémités du conducteur électrique 14 sont soudées sur les plots 15 et 16 par la technique du soudage en biseau ou « wedge bonding ». Ainsi, un ou plusieurs composants électroniques de la carte électronique 12 est ou sont connectés à un ou plusieurs composants électroniques de la carte électronique 13.

Comme le montre la figure 1, une résine d'enrobage 17 a été coulée et polymérisée dans le carter 11 de manière à enrober les deux cartes électroniques. Ainsi les extrémités soudées du conducteur électrique 14 sont protégées de l'oxydation, des chocs thermiques, des vibrations et de la chaleur humide.

La figure 1 montre un mode de réalisation de l'invention où les cartes électroniques sont complètement enrobées de résine, ce qui a pour effet de protéger également les composants situés sur les cartes électroniques et les cartes elles-mêmes qui sont soumises notamment à des contraintes de vibration.

La résine de protection pourrait aussi n'être distribuée que sur l'une des extrémités soudées du conducteur électrique, ou sur les deux extrémités de ce conducteur électrique.

La figure 2 représente un deuxième exemple de mise en oeuvre de l'invention. Dans cet exemple, le boîtier électronique 20 comprend un carter 21 contenant deux cartes électroniques 22 et 23. Comme dans l'exemple précédent, les cartes électroniques 22 et 23 sont fixées au carter 21 par des moyens de fixation non représentées. Comme précédemment aussi, la carte électronique 22 est une carte de puissance et la carte électronique 23 est une carte de commande. Le conducteur électrique 24 relie électriquement un plot électriquement conducteur 25 de la carte électronique 22 à un plot électriquement conducteur 26 de la carte électronique 23. Les extrémités du conducteur électrique 24 sont soudées sur les plots 25 et 26 par la technique du « wedge bonding ».

Dans le cas du boîtier illustré par la figure 2, une résine d'enrobage 27 a été coulée et polymérisée dans le carter 21 de manière à enrober seulement la carte électronique 22.

La résine polyuréthane utilisée pour mettre en oeuvre la présente invention peut être une résine commercialisée par la société SEG Diélectriques et polymérisable à température ambiante. On peut ainsi obtenir des boîtiers électroniques résistant à des chocs thermiques entre -40°C et +125°C et satisfaisants à des tests de vibration pour une vibration supérieure à 30 G.

La résine polyuréthane permet l'évacuation de calories générées par les cartes électroniques de puissance, à raison de 0,4 W/m.°C, vers le carter métallique du boîtier.

L'utilisation d'une résine polyuréthane permet d'éviter l'utilisation d'un four de polymérisation. Le boîtier électronique illustré à la figure 1, où le conducteur électrique de liaison est complètement enrobé de résine, présente l'avantage de ne pas nécessiter de robot de dépose de résine et de l'ensemble comprenant une lampe UV et un guide de fibres optiques pour la polymérisation. Le temps de cycle de fabrication est réduit.

Le prix de la résine polyuréthane est aussi avantageux. Ainsi, on estime diminuer, pour l'exemple illustré par la figure 1, de 75% le coût de mise en oeuvre par rapport à une résine époxy. En outre, la résine polyuréthane favorise l'évacuation des calories.

La résine polyuréthane est par exemple un matériau appartenant à l'échelle de dureté shore A.

L'invention concerne également un module de puissance comprenant au moins un composant de puissance. Le module de puissance comprend un boîtier dans lequel le composant de puissance est monté et contenant de la résine polyuréthane pour protéger le composant tel que décrit dans le boîtier électronique ci-dessus. Le composant de puissance est par exemple une puce électronique. De préférence, le composant de puissance est relié électriquement avec un plot électriquement conducteur 15, 16, 25, 26 ou avec un autre composant de puissance par des conducteurs 14 soudés par la technique du « wedge bonding » tel que précédemment décrit. Le conducteur électrique 14 est soudé sur une plage de soudure respective du composant.

Dans un mode de réalisation, le conducteur 14 et les plages de soudure des composants ou les plots électriquement conducteurs 15, 16, 25, 26 présentent des caractéristiques permettant d'obtenir une forme de conducteur électrique 14 améliorant sa tenue dans la résine polyuréthane, en particulier sa tenue mécanique. En particulier, le conducteur électrique 14 a une forme coudée au voisinage du plot conducteur 15, 16, 25, 26 ou de la plage de soudure.

Par exemple, le conducteur 14 est soudé à ses deux extrémités, et la distance horizontale entre les deux soudures est supérieure ou égale à 6 mm. La distance verticale entre les deux soudures peut être inférieure ou égale à 10 mm, et la longueur du conducteur 14 peut être inférieure ou égale à une valeur de 150xD où D est le diamètre du conducteur 14. Le conducteur 14 a un diamètre D compris entre 300 et 500 µm. Ces caractéristiques améliorent la tenue du conducteur 14 dans la résine polyuréthane.

## Revendications

1. Boîtier électronique (10, 20) destiné à être embarqué dans un véhicule, le boîtier comprenant un carter (11, 21) contenant au moins deux cartes électroniques (12, 13 ; 22, 23) reliées entre elles par au moins un conducteur électrique (14, 24), le conducteur ayant l'une de ses extrémités soudée sur l'une des cartes électroniques et l'autre de ses extrémités soudée sur l'autre carte électronique, le carter contenant en outre une résine de protection (17, 27) enrobant au moins l'une des extrémités soudées du conducteur électrique, la résine de protection est une résine polyuréthane, **caractérisé en ce que** le conducteur (14) a un diamètre (D) compris entre 300 et 500 µm et **en ce que** les extrémités du conducteur étant soudées par la technique du soudage en biseau, c.-à-d. « wedge bonding ».

2. Boîtier électronique selon la revendication 1, dans lequel l'une (12, 22) des deux cartes électroniques est une carte de puissance, l'autre carte électronique (13, 23) étant une carte de commande.

3. Boîtier électronique selon la revendication 2, dans lequel la résine de protection (17) enrobe complètement les cartes électroniques (13, 23).

4. Boîtier électronique selon la revendication 2, dans lequel la résine de protection (27) n'enrobe que la carte électronique de puissance (22).

5. Boîtier électronique selon la revendication 4, dans lequel la carte de commande (23) repose sur la résine d'enrobage (27).

6. Boîtier électronique selon l'une quelconque des revendications 1 à 5, dans lequel le conducteur électrique (14, 24) est un fil d'aluminium.

7. Boîtier électronique selon l'une quelconque des revendications 1 à 5, dans lequel le conducteur électrique (14, 24) est un ruban d'aluminium.

8. Boîtier électronique selon l'une quelconque des revendications 1 à 7, dans lequel le carter (11, 21) est en aluminium.

## Patentansprüche

1. Elektronikgehäuse (10, 20), das dazu bestimmt ist, in einem Fahrzeug eingebaut zu werden kann, wobei das Gehäuse einen Kasten (11, 21) aufweist, der mindestens zwei Leiterplatten (12, 13; 22, 23) enthält, die durch mindestens einen elektrischen Leiter (14, 24) miteinander verbunden sind, wobei der Leiter mit einem seiner Enden an der einen der Leiterplatten und mit dem anderen seiner Enden an der anderen Leiterplatte verschweißt ist, wobei der Kasten ferner ein Schutzharz (17, 27) enthält, das mindestens eines der verschweißten Enden des elektrischen Leiters umhüllt, wobei das Schutzharz ein Polyurethanharz ist, **dadurch gekennzeichnet, dass** der Leiter (14) einen Durchmesser (D) zwischen 300 und 500 µm aufweist und dass die Enden des Leiters durch die Schweißtechnik des Keilschweißens, d.h. "Wedge-Bonding" verschweißt sind.

2. Elektronikgehäuse nach Anspruch 1, wobei die eine (12, 22) der zwei Leiterplätten eine Leistungsplatine und die andere Leiterplatte (13, 23) eine Steuerplatine ist.

3. Elektronikgehäuse nach Anspruch 2, wobei das Schutzharz (17) die Leiterplatten (13, 23) vollständig umhüllt.

4. Elektronikgehäuse nach Anspruch 2, wobei das Schutzharz (27) nur die Leistungsplatine (22) umhüllt.

5. Elektronikgehäuse nach Anspruch 4, wobei die Steuerplatine (23) auf dem Umhüllungsharz (27) ruht.

6. Elektronikgehäuse nach einem der Ansprüche 1 bis 5, wobei der elektrische Leiter (14, 24) ein Aluminiumdraht ist.

7. Elektronikgehäuse nach einem der Ansprüche 1 bis 5, wobei der elektrische Leiter (14, 24) ein Aluminiumband ist.

8. Elektronikgehäuse nach einem der Ansprüche 1 bis 7, wobei der Kasten (11, 21) aus Aluminium ist.

## Claims

1. Electronic module (10, 20) designed to be installed in a vehicle, the module comprising a casing (11, 21) containing at least two circuit boards (12, 13; 22, 23) connected together by at least one electrical conductor (14, 24), the conductor having one of its ends bonded to one of the circuit boards and the other of its ends bonded to the other circuit board, the casing also containing a protective resin (17, 27) coating at least one of the bonded ends of the electrical conductor, protective resin being a polyurethane resin, **characterized in that** the conductor (14) has a diameter (D) of between 300 and 500 mm and **in that** the ends of the conductor are bonded by the "wedge bonding" technique.

2. Electronic module according to Claim 1, in which one (12, 22) of the two circuit boards is a power board, the other circuit board (13, 23) being a control board.

3. Electronic module according to Claim 2, in which the protective resin (17) completely coats the circuit boards (13, 23).

4. Electronic module according to Claim 2, in which the protective resin (27) coats only the power circuit board (22).

5. Electronic module according to Claim 4, in which the control board (23) rests on the coating resin (27).

6. Electronic module according to any one of Claims 1 to 5, in which the electrical conductor (14, 24) is an aluminium wire.

7. Electronic module according to any one of Claims 1 to 5, in which the electrical conductor (14, 24) is an aluminium ribbon.

8. Electronic module according to any one of Claims 1 to 7, in which the casing (11, 21) is made of aluminium.
